(19) Europäisches Patentamt

European Patent Office

Office européen des brevets

(11) **EP 0 704 970 A1**

(12) **DEMANDE DE BREVET EUROPEEN**

(43) Date de publication:
03.04.1996 Bulletin 1996/14

(51) Int. Cl.⁶: **H03K 5/13**, H03K 19/003

(21) Numéro de dépôt: 95115045.7

(22) Date de dépôt: 25.09.1995

(84) Etats contractants désignés:
DE ES FR GB IT

(30) Priorité: 29.09.19 94 FR 9411664

(71) Demandeur: VALEO ELECTRONIQUE
F-94042 Creteil Cédex (FR)

(72) Inventeur: **Leconte, Eric**
**F-94450 Limeil Brevannes (FR)**

(74) Mandataire: **Gamonal, Didier et al**
**Valeo Management Services**
**Sce Propriété Industrielle**
**2, rue André Boulle**

(54) **Circuit monostable à faibles dispersions du temps de basculement et circuit électronique l'incorporant**

(57) La présente invention concerne un circuit monostable à faibles dispersions du temps de basculement. Elle concerne aussi un circuit électronique l'incorporant.

Selon l'invention, deux amplificateurs (3, 7) ayant sensiblement le même seuil de basculement (Vth1, Vth2) sont connectés en série avec des circuits de charge capacitifs (2, 6) de sorte que le basculement tardif, respectivement rapide, du second amplificateur soit compensé par le basculement rapide, respectivement tardif, du premier amplificateur.

Application à la fabrication de modules électroniques de grandes séries avec des composants à forte dispersion.

Figure 1

**Description**

La présente invention concerne un circuit monostable à faibles dispersions du temps de basculement. Elle concerne aussi un circuit électronique l'incorporant.

Dans l'état de la technique, on connaît des circuits monostables, dits ci-après des monostables, dont une borne de sortie délivre un signal binaire qui présente un changement d'état généré automatiquement après l'apparition d'un changement d'état contenu dans un signal binaire appliqué sur une borne d'entrée.

Le temps de basculement du monostable est largement déterminé par un circuit capacitif et on sait, pour un monostable donné, obtenir des précisions presque aussi élevées qu'on le désire, pour la définition de ce temps de basculement.

Cependant, le problème à la base de l'invention est provoqué par les très importantes dispersions que l'on relève sur les paramètres de fonctionnement des circuits intégrés qui incorporent de tels dispositifs monostables. Or, de très nombreux circuits électroniques mettent en oeuvre le monostable pour la mise en forme de signaux notamment.

De ce fait, des circuits électroniques destinés à exécuter des fonctions précises peuvent très bien fonctionner avec un échantillon de circuit intégré lors de son développement et donner des fonctionnements imprévus avec d'autres. Pour le cas de fabrications en grandes quantités de circuits électroniques, il faut donc prévoir, comme c'est le cas pour les équipements électroniques automobiles, des mécanismes d'adaptation qui permettent au circuit électronique de fonctionner selon le mode prévu malgré d'éventuelles dispersions sur les composants électroniques (circuits intégrés) choisis.

Ces dispositifs d'adaptation ou d'auto-adaptation, sont difficiles à concevoir et ne font pas toujours face à certaines situations exceptionnelles.

On a parfois recours à des techniques de tri statistique qui permettent, pour une gamme de fabrications donnée, de s'approvisionner en composants électroniques dont leur fabricant garantit que la dispersion sur leurs caractéristiques est inférieure à une valeur déterminée. Mais, quand ce tri est possible, il augmente considérablement le coût d'approvisionnement des composants.

La présente invention apporte remède à cet inconvénient de l'état de la technique en proposant un circuit monostable dont la dispersion sur la caractéristique en temps de basculement est plus réduite que celle sur les autres paramètres de fonctionnement du circuit. Elle se caractérise notamment en ce que le circuit monostable est constitué d'un premier amplificateur inverseur dont la borne d'entrée est chargée par l'intermédiaire d'un premier circuit de charge capacitif connecté à une polarité positive et dont la sortie est connectée à la borne d'entrée d'un second amplificateur qui est chargée par l'intermédiaire d'un second circuit de charge capacitif connecté à une polarité négative ou à la masse, les deux amplificateurs ayant un seuil de basculement sensiblement égal de sorte que le basculement tardif, respectivement rapide, du second amplificateur soit compensé par le basculement rapide, respectivement tardif, du premier amplificateur.

Selon un autre aspect de l'invention, le second amplificateur est un amplificateur inverseur.

Selon un aspect de l'invention, les amplificateurs sont implantés sur le même substrat d'un circuit intégré.

Selon un autre aspect de l'invention, les circuits de charge sont dotés de moyens de sélection de constantes de temps prédéterminées.

Selon un autre aspect de l'invention, le premier circuit de charge capacitif et le second circuit de charge capacitif ont des constantes de temps égales.

L'invention concerne aussi un circuit électronique incorporant un circuit monostable tel que défini ci-dessus.

D'autres caractéristiques et avantages de la présente invention seront mieux compris à l'aide de la description et des figures qui sont :

- la figure 1 : un schéma d'un circuit monostable selon l'invention ;
- la figure 2 : un chronogramme de fonctionnement du monostable de la figure 2.

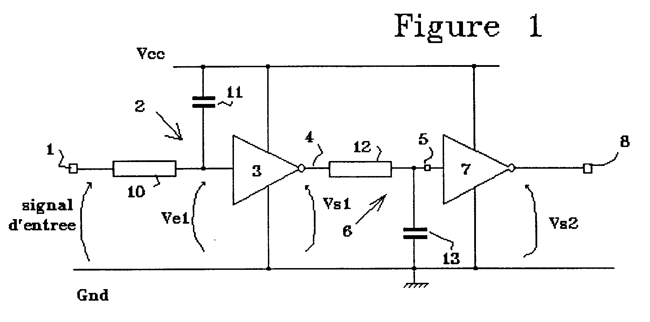

A la figure 1, on a représenté un mode de réalisation d'un circuit monostable selon l'invention. La borne d'entrée 1 du circuit est connectée par un circuit de charge 2 à la borne d'entrée d'un premier amplificateur 3, de type inverseur. La borne de sortie inverseuse 4 du premier amplificateur 3 est connectée à la borne d'entrée 5 d'un second amplificateur inverseur 7 par l'intermédiaire d'un circuit de charge capacitif 6. La borne de sortie 8 du second amplificateur 7 sert de borne de sortie au monostable de l'invention.

Dans un mode de réalisation préféré de l'invention, les deux amplificateurs du monostable sont identiques. Afin de garantir des seuils de basculement égaux, ils doivent être fabriqués sur le même substrat semi-conducteur, ce qui est le cas quand les deux amplificateurs sont intégrés dans un même circuit intégré. Dans une telle circonstance, les deux amplificateurs présentent la même tension de seuil ce qui simplifie la conception du circuit monostable.

Les circuits de charge capacitif 2 et 6 sont respectivement constituées par des résistances 10 et 12 connectées en série sur le chemin du signal d'entrée. Un condensateur 11 ou 13 est connecté entre une polarité et la résistance. Le premier circuit de charge 2 est connecté à la polarité positive Vcc tandis que le second circuit de charge 6 est connecté à la polarité négative ou à la masse Gnd.

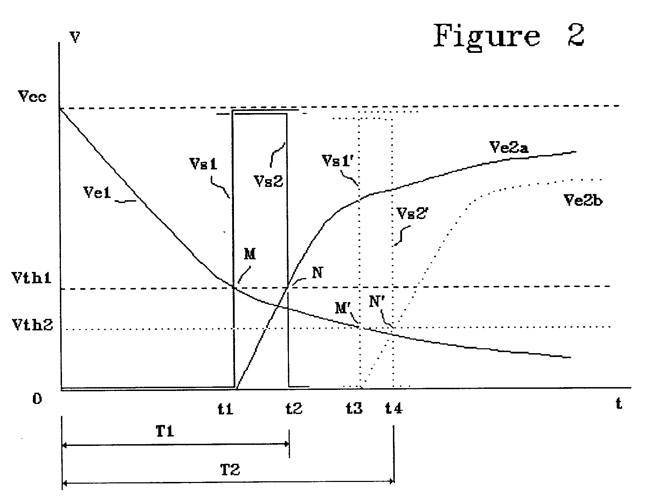

A la figure 2, on a représenté des chronogrammes de fonctionnement du circuit de la figure 1.

Les amplificateurs inverseurs utilisés présentent une tension de seuil Vth, telle que pour une tension d'entrée inférieure à sa valeur, leur borne de sortie se bloque à la tension de polarisation la plus forte, Vcc.

Si le signal d'entrée est à l'état haut (Vcc) depuis un temps suffisant, le premier condensateur 11 est déchargé, puisqu'il est connecté à la tension positive Vcc.

A l'instant 0, représenté sur le graphe de la figure 2, lorsque le signal d'entrée (appliqué sur la borne 1 du circuit de la figure 1) passe de la tension haute Vcc à la tension nulle Gnd représentative d'un état logique bas, le condensateur se charge sur l'entrée du premier amplificateur 3. La tension Ve1 appliquée sur la borne d'entrée du premier amplificateur suit donc une loi exponentielle qui s'exprime en fonction du temps t par :

$$Ve1 = Vcc^*exp(-t/R1^*C1)$$

où R1 est la valeur de la résistance 10 et C1 la capacité du condensateur 11, courbe qui est représenté en trait plein à la figure 2.

Quand la tension d'entrée Ve1 atteint la tension de seuil de l'amplicateur: soit Vth1, représentée par la droite horizontale en tirets, qu'elle coupe au point M, à la date t1, la borne de sortie du premier amplificateur bascule à l'état logique haut et suit la courbe Vs1.

De ce fait, le second condensateur 13 se charge à travers la résistance 12 et la tension présentée à la borne d'entrée 5 du second amplificateur 7 est représentée par une courbe Ve2a qui s'exprime par :

$$Ve2a = Vcc(1-exp(t1-t/R2^*C2))$$

où R2 est la valeur de la résistance 12 et C2 la capacité du condensateur 13.

Le second amplificateur étant inverseur, sa sortie est initialement à l'état haut ( Vs2 = Vcc ), mais quand la tension d'entrée Ve2a atteint la valeur de seuil Vth1 commune aux deux amplificateurs inverseurs, qui sont réalisés sur le même substrat du circuit intégré, au point N à la date t2, la sortie bascule à l'état bas selon la courbe Vs2.

De ce fait, la borne de sortie 8 du circuit monostable de l'invention, doté de deux étages d'amplificateurs, recopie l'état de la borne d'entrée 1 après une durée T1, dite temps de basculement, qui débute à t=0 et se termine à t=t2 .

Mais, soit un autre circuit intégré présentant une tension de seuil Vth2, représentée en pointillés à la figure 2, de valeur inférieure à la valeur Vth1. Cette situation arrive particulièrement dans un lot de circuits intégrés présentant une forte dispersion sur la valeur du seuil de basculement Vth.

Dans ce cas, le premier amplificateur basculera à la date t3, plus tardive que la date t1 précédente, et le second amplificateur basculera à la date t4 représentée lorsque la courbe de charge Ve2b coupe en N' la droite V = Vth2 .

La dispersion sur la valeur du temps de basculement du circuit monostable s'écrit comme la différence entre les temps extrêmes T1 et T2. Or :

$$Vth1 = Vcc^*exp(-t1/(R1^*C1)) : \text{pour la décharge Ve1}$$
$$= Vcc^*(1-exp((t1-t2)/(R2^*C2))) : \text{pour la charge Ve2a}$$

et

$$Vth2 = Vcc^*exp(-t3/(R1^*C1)) : \text{pour la décharge Ve1}$$
$$= Vcc^*(1-exp((t3-t4)/(R2^*C2))) : \text{pour la charge Ve2b}$$

On exprime alors les durées par inversion logarithmique en :

$$t1 = R1^*C1^*Ln(Vcc/Vth1)$$

$$t2 = t1 + R2^*C2^* Ln(Vcc/(Vcc-Vth1))$$

$$t3 = R1^*C1^*Ln(Vcc/Vth2)$$

$$t4 = t3 + R2^*C2^* Ln(Vcc/(Vcc-Vth2))$$

La durée de basculement prise pour le seuil à Vth1 est définie par:

$$T1 = t2 - 0$$

La durée de basculement prise pour le seuil à Vth2 est définie par:

$$T2 = t4 - 0$$

La dispersion DT est donc définie pour une valeur de seuil maximale Vth1 et une valeur de seuil minimale Vth2 mesurées sur un lot de circuits intégrés incorporant l'invention :

$$DT = T2 - T1 = t4 - t2$$
$$= t3 + R2*C2*Ln(Vcc/(Vcc-Vth2)) - t1 - R2*C2*Ln(Vcc/(Vcc-Vth1))$$
$$= R1*C1*Ln(Vth1/Vth2) + R2*C2*Ln(Vcc-Vth1)/(Vcc-Vth2))$$

Dans le cas où les circuits monostables auraient été réalisés avec un seul amplificateur, par exemple le premier amplificateur du schéma de la figure 1, la dispersion sur les temps de basculement aurait été exprimée par :

$$DT0 = t3 - t1$$
$$= R1*C1*Ln(Vth1/Vth2)$$

On a donc :

$$DT = DT0 + R2*C2*Ln((Vcc-Vth1)/(Vcc-Vth2))$$

Or : Vth2 < Vth1 entraîne :

$$Vth1/Vth2 > 1 \text{ et } (Vcc - Vth1) / (Vcc- Vth2) < 1$$

Or, le logarithme d'un nombre plus petit que l'unité est négatif. Ce qui entraîne que la dispersion DT du circuit de la figure 1 est plus petite que la dispersion DT0 du circuit monostable de l'état de la technique avec un seul amplificateur chargé par un seul réseau RC.

La description a été faite pour un circuit monostable comportant deux amplificateurs inverseurs réalisés sur un seul substrat, comme c'est le cas quand les deux amplificateurs sont choisis sur un même circuit intégré comme le circuit CD4049. Les tensions de seuils des deux amplificateurs sont alors égales et, avec des circuits de charge capacitifs ayant la même constante de temps, on a ainsi des seuils de basculement égaux.

Il est bien entendu que l'invention s'applique aussi à d'autres montages par exemple, un montage utilisant comme second amplificateur, un amplificateur non inverseur.

Le circuit de charge de chaque réseau d'entrée des amplificateurs du circuit de l'invention peut être constitué par des circuits plus complexes, par exemple, en les dotant de moyens, connus en soi, de sélection de constantes de temps prédéteminées. Ils permettent d'adapter la constante de temps des réseaux de charge de chaque amplificateur, ou encore de leur donner une constante de temps différente selon les circonstances, et notamment une constante de temps différente à la charge et à la décharge du condensateur.

Par ailleurs, plusieurs monostables peuvent être cumulés.

## Revendications

**1.** Circuit monostable, caractérisé en ce qu'il est constitué d'un premier amplificateur inverseur (3) dont la borne d'entrée est chargée par l'intermédiaire d'un premier circuit de charge capacitif (2) connecté à une polarité positive, et dont la sortie (4) est connectée à la borne d'entrée (5) d'un second amplificateur (7) qui est chargée par l'intermédiaire d'un second circuit de charge capacitif (6) connecté à une polarité négative ou à la masse, les deux amplificateurs ayant des tensions de seuil (Vth1, Vth2) sensiblement égales de sorte que le basculement tardif, respectivement rapide, du second amplificateur soit compensé par le basculement rapide, respectivement tardif, du premier amplificateur.

**2.** Circuit selon la revendication 1, caractérisé en ce que le second amplificateur (7) est un amplificateur inverseur.

**3.** Circuit selon la revendication 1 ou la revendication 2, caractérisé en ce que les amplificateurs (3, 7) sont implantés sur le même substrat d'un circuit intégré.

**3.** Circuit selon la revendication 1, caractérisé en ce que les circuits de charge capacitifs (2, 6) sont dotés de moyens de sélection de constantes de temps prédéterminées.

**4.** Circuit selon la revendication précédente, caractérisé en ce que le premier circuit de charge capacitif (2) et le second circuit de charge capacitif (6) ont des constantes de temps (R1*C1, R2*C2) égales.

**5.** Circuit électronique incorporant au moins un circuit monostable selon l'une des revendications précédentes.

# Figure 1

Figure 2

Office européen
des brevets

**RAPPORT DE RECHERCHE EUROPEENNE**

Numero de la demande

EP 95 11 5045

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| X | RADIO FERNSEHEN ELEKTRONIK, vol. 35, no. 8, 1986 BERLIN, GDR, pages 497-498, G. TURINSKY * le document en entier * | 1-5 | H03K5/13 H03K19/003 |
| A | EP-A-0 334 983 (ITT IND GMBH DEUTSCHE) 4 Octobre 1989 * abrégé; figures 1,2 * | 1-5 | |
| A | EP-A-0 219 291 (YAMAHA CORPORATION) 22 Avril 1987 | | |

| | | DOMAINES TECHNIQUES RECHERCHES (Int.Cl.6) |
|---|---|---|
| | | H03K |

Le présent rapport a été établi pour toutes les revendications

| Lieu de la recherche | Date d'achèvement de la recherche | Examinateur |
|---|---|---|
| LA HAYE | 27 Décembre 1995 | Segaert, P |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
& : membre de la même famille, document correspondant

EPO FORM 1503 03.82 (P04C02)